# EUROPEAN PATENT APPLICATION

(11) **EP 4 401 251 A1**
(43) Date of publication of application: **17.07.2024**
(21) Application number: 22866215.1
(22) Date of filing: 01.07.2022
(51) Int. Cl.: H01S 5/026, H01S 5/042, H01S 5/02, H01S 5/40

(54) **LASER, FABRICATION METHOD THEREFOR, AND LASER DEVICE**

(30) Priority: 09.09.2021 CN 202111057956
(71) Applicant: Innolight Technology (Suzhou) Ltd., Suzhou, Jiangsu 215000 (CN)
(72) Inventor: ZHENG, Xuezhe, Suzhou, Jiangsu 215000 (CN); DU, Yinchao, Suzhou, Jiangsu 215000 (CN); TENG, Min, Suzhou, Jiangsu 215000 (CN)
(74) Representative: Becker, Eberhard
(86) International application number: PCT/CN2022/103216
(87) International publication number: WO 2023/035740

(57) **Abstract**

A laser capable of reducing the difficulty of a wavelength tuning process, a fabrication method therefor, and a laser device. The laser comprises: an active light-emitting structure (100) used for emitting light; a silicon-based structure (200) which is bonded to the active light-emitting structure (100), and which comprises a silicon-based waveguide (210) and at least two composite gratings (211), wherein the composite gratings (211) are opposite to the active light-emitting structure (100) and are formed in the silicon-based waveguide (210). Each composite grating (211) comprises one primary grating and a plurality of secondary gratings (2111), the secondary gratings (2111) are periodically arranged to form the primary grating, and the primary gratings in at least a portion of the composite gratings (211) have different grating periods (T) from that of the primary gratings in other composite gratings (211). The silicon-based structure (200) and the active light-emitting structure (100) form at least two laser units, and each laser unit corresponds to one composite grating (211).

## Description

### CROSS-REFERENCE TO RELATED APPLICATION

This application is a continuation of international PCT application serial no. PCT/CN2022/103216, filed on July 01, 2022, which claims a priority and benefit of China application no. 202111057956.1, filed on September 09, 2021. The entirety of each of the above-mentioned patent applications is hereby incorporated by reference and made a part of this specification.

### BACKGROUND

### Technical Field

The disclosure relates to the field of laser technology, and in particular, to a laser, a fabrication method therefor, and a laser device.

### Description of Related Art

Tunable lasers are one of the most important components in optical modules because tunable lasers can change the laser output wavelength within a certain range. This type of lasers can be widely used.

However, most of the currently-available tunable lasers use the vernier effect of the structure to achieve wavelength tunability within a certain wavelength range. The process of this method is relatively difficult, leading to the high fabrication costs of the currently-available tunable lasers.

### SUMMARY

### Technical Problems

Based on the above, it is necessary to provide a laser, a fabrication method therefor, and a laser device to solve the problems found in the related art.

### Solutions to Problems

### Technical Solutions

A laser, including:
an active light-emitting structure used for emitting light; and
a silicon-based structure bonded to the active light-emitting structure and including a silicon-based waveguide and at least two composite gratings, where the composite gratings are opposite to the active light-emitting structure and are formed in the silicon-based waveguide, each composite grating includes one primary grating and a plurality of secondary gratings, the secondary gratings are periodically arranged to form the primary grating, and the primary gratings in at least a portion of the composite gratings have different grating periods from that of the primary gratings in other composite gratings,
where the silicon-based structure and the active light-emitting structure form at least two laser units, and each laser unit corresponds to one composite grating.

In one of the embodiments, the active light-emitting structure includes a plurality of active light-emitting units, the active light-emitting units are all bonded to the silicon-based structure and opposite to the composite gratings, and gain materials of the active light-emitting units are different.

In one of the embodiments, the active light-emitting structure includes a plurality of active light-emitting units, the active light-emitting units are all bonded to the silicon-based structure and opposite to the composite gratings, and gain materials of the active light-emitting units are the same.

In one of the embodiments, the same active light-emitting unit is opposite to the plurality of composite gratings.

In one of the embodiments, the laser units are arranged in an array, the laser units located in a same row are connected in series through the same silicon-based waveguide, and the laser units located in a same column are connected in parallel through different silicon-based waveguides.

In one of the embodiments, the grating periods of the primary gratings in the composite gratings corresponding to the laser units located in the same row or the same column are the same.

In one of the embodiments, the silicon-based structure further includes:
a first dielectric layer located on a side of the silicon-based waveguide on which the composite gratings are not formed and bonded to the active light-emitting structure; and
a second dielectric layer covering a side of the silicon-based waveguide on which the composite gratings are formed and the first dielectric layer.

In one of the embodiments, the silicon-based structure further includes:
a supporting substrate; and
a light-absorbing layer located on a side of the second dielectric layer away from the silicon-based waveguide and bonded onto the supporting substrate.

In one of the embodiments, a coupling structure is also formed in the silicon-based waveguide, the coupling structure is located between the active light-emitting structure and an output end of the laser and is located in a transmission direction of the silicon-based waveguide, and a width of the coupling structure gradually increases outward from the active light-emitting structure.

A laser device, including:
the laser according to any one of the above; and
a control circuit used for controlling a switch of each of the laser units.

A fabrication method for a laser, including:
forming a silicon-based structure including a silicon-based waveguide and at least two composite gratings, where the composite gratings are formed in the silicon-based waveguide, each composite grating includes one primary grating and a plurality of secondary gratings, the secondary gratings are periodically arranged to form the primary grating, and the primary gratings in at least a portion of the composite gratings have different grating periods from that of the primary gratings in other composite gratings;
bonding a light-emitting substrate to the silicon-based structure; and
patterning the light-emitting substrate to form an active light-emitting structure, where the active light-emitting structure is opposite to the composite gratings.

In one of the embodiments, the forming the silicon-based structure includes:
providing a silicon-based substrate including a base substrate, an insulating layer, and a waveguide layer, where the insulating layer is formed on the base substrate, and the waveguide layer is formed on the insulating layer;
patterning the waveguide layer to form the silicon-based waveguide and the composite gratings;
forming a second dielectric layer, where the second dielectric layer covers a side of the silicon-based waveguide on which the composite gratings are formed and the insulating layer; and
removing the base substrate and thinning the insulating layer, where the remaining insulating layer forms a first dielectric layer,
where the bonding the light-emitting substrate to the silicon-based structure includes:
bonding the light-emitting substrate to the first dielectric layer.

In one of the embodiments, before the removing the base substrate and thinning the insulating layer, further including:
forming a light-absorbing layer on a surface of the second dielectric layer; and
bonding to a supporting substrate through the light-absorbing layer.

In the laser, fabrication method therefore, and laser device, at least two laser units are formed through the silicon-based structure and the active light-emitting structure. Further, through the different grating periods of the primary grating in each composite grating of the silicon-based structure, the at least two laser units can emit light of different wavelengths. Moreover, in each laser unit, each composite grating may simultaneously perform wavelength tuning based on gratings of different precision levels through its internal primary grating and secondary gratings, so that the difficulty of a wavelength tuning process may be effectively reduced.

### Beneficial Effects of Disclosure

### Beneficial Effects

Further, the active light-emitting structure and the passive silicon-based structure are heterogeneously integrated in the disclosure. Each laser unit of the laser may output light through the passive silicon-based waveguide in this way. Therefore, after light of a predetermined wavelength is formed through grating adjustment, it may not be lost during the transmission process, so the difficulty of tuning is further reduced.

### BRIEF DESCRIPTION OF THE DRAWINGS

### Description of Accompanying Drawings

To make the technical solutions provided in the embodiments of the disclosure or the related art more clearly illustrated, several accompanying drawings required by the embodiments or the related art for description are briefly introduced as follows. Obviously, the drawings in the following description are merely some embodiments of the disclosure, and for a person having ordinary skill in the art, other drawings can be obtained based on these drawings without an inventive effort.
FIG. 1 is a schematic cross-sectional view of a partial structure of a laser provided in an embodiment.
FIG. 2 is a schematic cross-sectional view of a structure of a laser unit provided in an embodiment.
FIG. 3 is a schematic top view of the partial structure of the laser provided in an embodiment.
FIG. 4 is a schematic top view of the partial structure of the laser provided in another embodiment.
FIG. 5 is a schematic view of an arrangement structure of the laser provided in an embodiment.
FIG. 6 is a schematic flow chart of a fabrication method for a laser provided in an embodiment.

### DESCRIPTION OF THE EMBODIMENTS

### Implementation of the Disclosure

To facilitate understanding of the disclosure, the disclosure will be described more comprehensively below with reference to the relevant accompanying drawings. The embodiments of the disclosure are illustrated in the accompanying drawings. However, the disclosure can be implemented in many different forms and is not limited to the embodiments described herein. On the contrary, the purpose of providing these embodiments is to make the disclosed content of the disclosure more thorough and comprehensive.

Unless otherwise defined, all technical and scientific terms used in the specification have the same meaning as commonly understood by a person having ordinary skill in the art. The terms used herein in the specification of the disclosure are for the purpose of describing specific embodiments only, and are not intended to limit the disclosure.

It shall be understood that when an element or a layer is referred to as being "on", "adjacent to", "connected to", or "coupled to" another element or layer, it means that the element or layer can be directly on, adjacent to, connected to, or coupled to another element or layer, or it means that an intervening element or layer may be present. In contrast, when an element is referred to as being "directly on", "directly adjacent to", "directly connected to", or "directly coupled to" another element or layer, it means that there is no intervening element or layer present. It shall be understood that although the terms first, second, third, etc. may be used to describe various elements, components, regions, layers, doping types, and/or sections, these elements, components, regions, layers, doping types, and/or sections shall not be limited by these terms. These terms are only used to distinguish one element, component, region, layer, doping type, or section from another element, component, region, layer, doping type, or section. Therefore, a first element, component, region, layer, doping type, or section discussed in the following paragraphs could be termed a second element, component, region, layer, or section without departing from the teachings of the disclosure. For instance, a first doping type may become a second doping type, and similarly, the second doping type may become the first doping type. The first doping type and the second doping type are different doping types. For instance, the first doping type may be P type and the second doping type may be N type, or the first doping type may be N type and the second doping type may be P type.

Spatial relationship terms, such as "under", "below", "underlying", "beneath", "on", "above", etc., may be used herein to describe the relationship of one element or feature to other elements or features shown in the drawings. It should be understood that the spatially relative terms encompass different orientations of the device in use and operation in addition to the orientation depicted in the drawings. For instance, if the device in the drawings is turned over, elements or features described as "below", "under", or "beneath" other elements or features would then be oriented "above" the other elements or features. Therefore, the exemplary terms "below" and "under" may include both upper and lower orientations. In addition, the device may be otherwise oriented (e.g., rotated 90 degrees or at other orientations), and the spatial descriptors used herein are interpreted accordingly.

As used herein, the singular forms "a", "an", and "the" may include the plural forms as well, unless the context clearly dictates otherwise. It should also be understood that the terms "including/comprising" or "having" and the like designate the presence of stated features, integers, steps, operations, components, portions, or combinations thereof, but do not exclude the possibility of the presence or addition of one or more other features, integers, steps, operations, components, portions, or a combination thereof. Further, in the specification, the term "and/or" includes any and all combinations of the associated listed items.

The embodiments of the disclosure are described herein with reference to cross-sectional illustrations that are schematic illustrations of idealized embodiments (and intermediate structures) of the disclosure, such that variations in the shapes shown due to, for example, manufacturing techniques and/or tolerances, are contemplated. Therefore, the embodiments of the disclosure should not be limited to the specific shapes of regions shown herein but are to include deviations in shapes due to, for example, manufacturing techniques. For instance, an implanted region that appears as a rectangle typically has rounded or curved features and/or implant concentration gradients at its edges rather than a binary change from implanted to non-implanted region. Similarly, a buried region formed by an implant may result in some implantation in the area between the buried region and the surface through which the implant occurs. Therefore, the regions shown in the drawings are schematic in nature and their shapes do not represent the actual shapes of the regions of the device and do not limit the scope of the disclosure.

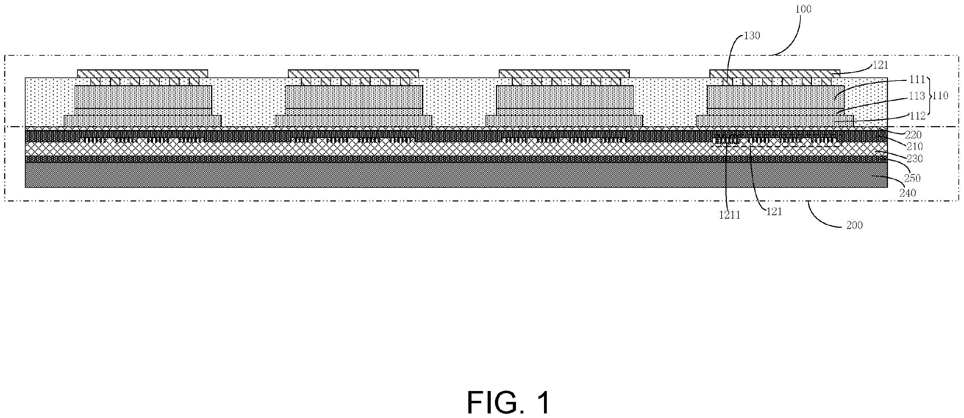

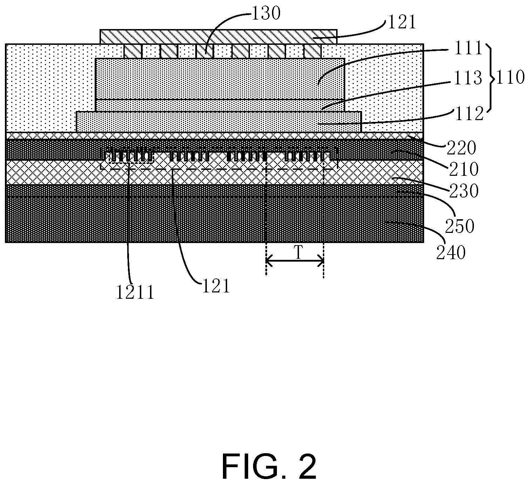

In an embodiment, with reference to FIG. 1 and FIG. 2, a laser including an active light-emitting structure 100 and a silicon-based structure 200 is provided.

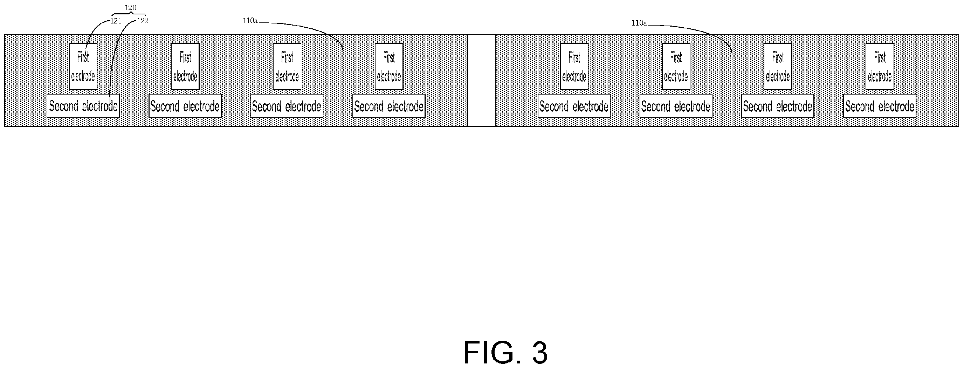

The active light-emitting structure 100 may include a light-emitting layer 110, and a material of the light-emitting layer 110 may be but not limited to an III-V gain material (e.g., InP). As an example, the light-emitting layer 110 may specifically include a P-type layer 111, an N-type layer 112, and a quantum well layer 113 therebetween. The P-type layer 111 and the N-type layer 112 may be connected to two electrodes 120 with different electrical properties and thus are capable of emitting light. To be specific, with reference to FIG. 3, the electrodes 120 may include a first electrode 121 and a second electrode 122. The first electrode 121 may be connected to the P-type layer 111 through a conductive plug 130. The second electrode 122 may be connected to the N-type layer 113 through the conductive plug 130 (not shown).

The silicon-based structure 200 includes a silicon-based waveguide 210 and composite gratings 211.

The silicon-based waveguide 210 may be used for light transmission. The composite gratings 211 are opposite to the active light-emitting structure 100, and the composite gratings 211 are formed in the silicon-based waveguide 210, so that the light emitted by the active light-emitting structure 100 may be effectively reflected and effectively transmitted in the silicon-based waveguide 210.

Further, in this embodiment, each composite grating 211 includes one primary grating and a plurality of secondary gratings 2111. The secondary gratings 2111 are periodically arranged to form the primary grating, so that light of a required wavelength may be formed through the superposition effect of the gratings with different precision levels, and the tuning of the wavelength may thus be easily performed.

In this embodiment, the silicon-based structure 200 includes at least two composite gratings 211. Therefore, the silicon-based structure 200 and the active light-emitting structure 100 may form at least two effective heterogeneous integrated laser units (with reference to FIG. 2), where each laser unit corresponds to one composite grating 211.

Further, in this embodiment, the primary gratings in at least a portion of the composite gratings 211 have different grating periods T from that of the primary gratings in other composite gratings 211.

The grating period T of the primary grating in one composite grating 211 is an arrangement period between adjacent secondary gratings 2111 in the composite grating 211.

Herein, in each composite grating 211, the primary grating has at least two different grating periods T, so that, so that the at least two laser units may form light of different wavelengths, and that the laser may be tuned at least two different wavelengths.

Therefore, the laser of this embodiment may form at least two laser units through the silicon-based structure 200 and the active light-emitting structure 100. Further, through the different grating periods of the primary grating in each composite grating 211 of the silicon-based structure 200, the at least two laser units may emit light of different wavelengths. Moreover, in each laser unit, each composite grating 211 may simultaneously perform wavelength tuning based on gratings of different precision levels through its internal primary grating and secondary gratings, so that the difficulty of a wavelength tuning process may be effectively reduced.

Further, the active light-emitting structure 100 and the passive silicon-based structure 200 are heterogeneously integrated in this embodiment. Each laser unit of the laser may output light through the passive silicon-based waveguide 210 in this way. Therefore, after light of a predetermined wavelength is formed through grating adjustment, it may not be lost during the transmission process, so the difficulty of tuning is further reduced.

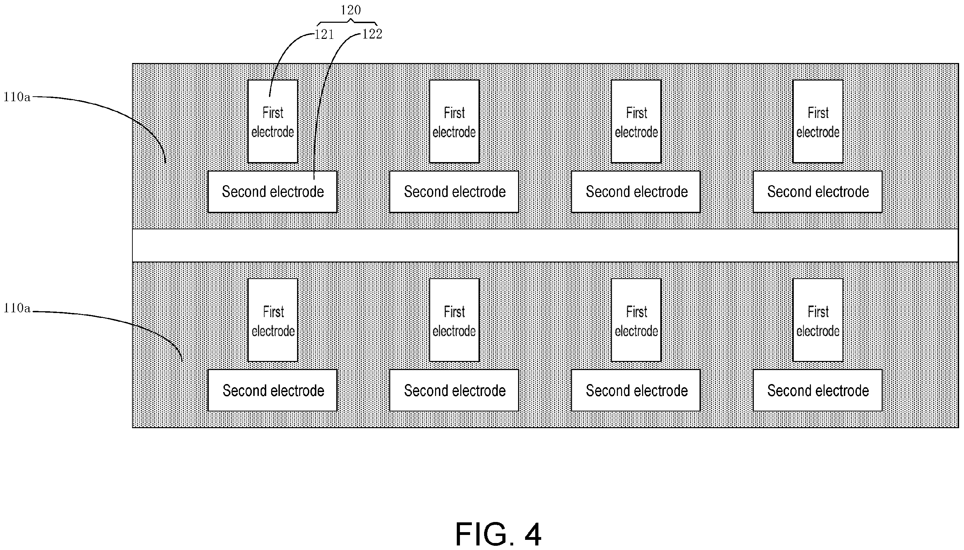

In an embodiment, with reference to FIG. 3 or FIG. 4., the active light-emitting structure 100 includes a plurality of active light-emitting units 100a, and the active light-emitting units have different gain materials, so that different photoelectric effects can occur.

The active light-emitting units 100a are all bonded to the silicon-based structure 200 and opposite to the composite gratings 211. Therefore, in this embodiment, the laser units corresponding to different active light-emitting units 100a may further tune the wavelength through differences in gain materials, so that the laser may emit laser light with a wider wavelength range.

Certainly, in some embodiments, the active light-emitting structure 100 includes a plurality of active light-emitting units 100a, and when the active light-emitting units 100a are all bonded to the silicon-based structure 200 and opposite to the composite gratings 211, the gain materials of the active light-emitting units may also be the same. Herein, the gain materials of the light-emitting layer 110 of the entire active light-emitting structure 100 are the same.

Alternatively, the active light-emitting structure 100 may also include only one active light-emitting unit 100a. This is not limited in the disclosure.

In an embodiment, with reference to FIG. 3 and FIG. 4, the same active light-emitting unit 100a is opposite to multiple composite gratings 211. Herein, the bonding of the active light-emitting unit 100a and the silicon-based structure 200 may be easily performed.

Certainly, the disclosure is not limited thereto. For instance, in other embodiments, one active light-emitting unit 100a may correspond to one composite grating 211, thereby forming a laser unit.

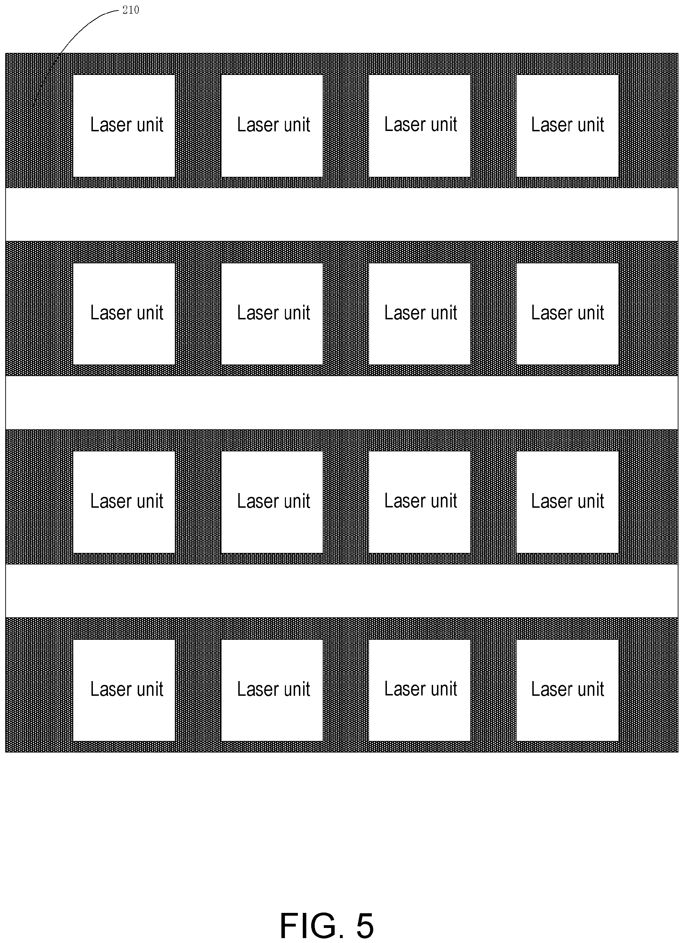

In one embodiment, with reference to FIG. 5, the laser units are arranged in an array, the laser units located in a same row are connected in series through the same silicon-based waveguide 210, and the laser units located in a same column are connected in parallel through different silicon-based waveguides 210.

Herein, to be specific, the composite gratings 211 of the laser units in the same row are formed on the same silicon-based waveguide 210, so that the laser units located in the same row are connected in series through the same silicon-based waveguide 210.

The composite gratings 211 of the laser units in different rows are formed on different silicon-based waveguides 210, so that the laser units located in the same column are connected in parallel through different silicon-based waveguides 210.

Through the series and parallel connection of the laser units, the light emitted by the laser units may be uniformly outputted.

Further, in the laser of this embodiment, since the laser units connected in series transmit light through the passive silicon-based waveguide, none of the laser units will cause loss in this transmission path, so the wavelength may be easily tuned.

In an embodiment, the grating periods T of the primary gratings in the composite gratings 211 corresponding to the laser units located in the same row (or the same column) are the same.

Herein, if the gain materials of the light-emitting layer 110 of the entire active light-emitting structure 100 are the same, the laser units located in the same row (or the same column) may output light of the same wavelength. When the laser emits laser light of a corresponding wavelength, the laser units in that row may be turned on at the same time, and laser intensity may thus be effectively increased.

Herein, further, the electrodes of the same polarity of the laser units located in the same row (or the same column) may be connected together to form an electrode plate for easy control.

Similarly, if the active light-emitting structure includes multiple (e.g., two) active light-emitting units 100a, the laser units corresponding to the same active light-emitting unit 100a located in the same row (or the same column) can output light of the same wavelength. When the laser emits laser light of a corresponding wavelength, the laser units in the corresponding active light-emitting units 100a of the row may be turned on at the same time, and the laser intensity is thus effectively increased.

Herein, further, the electrodes of the same polarity of the light units corresponding to the same active light-emitting unit 100a located in the same row (or the same column) may also be connected together to form an electrode plate for easy control.

Certainly, the electrodes of the same polarity of each laser unit may still be arranged separately, and there is no limitation on this herein.

Alternatively, in other embodiments, the laser units with the same grating period T of the primary gratings in the composite gratings 211 may also be arranged in different rows and columns in other forms.

Alternatively, in other embodiments, the grating periods T of the primary gratings in the composite gratings 211 of the laser unit may also be different. This is not limited in the herein.

In an embodiment, the silicon-based structure 200 further includes a first dielectric layer 220 and a second dielectric layer 230. A material of the first dielectric layer 220 and/or the second dielectric layer 230 may be but not limited to silicon dioxide or the like.

The first dielectric layer 220 is located on a side of the silicon-based waveguide 210 on which the composite gratings 211 are not formed, so that the silicon-based structure 200 may be effectively bonded to the active light-emitting structure 100 through the first dielectric layer 220.

The second dielectric layer 230 covers a side of the silicon-based waveguide 210 on which the composite gratings 211 are formed and the first dielectric layer 220, so that the second dielectric layer 230 effectively covers the silicon-based waveguide 210 together with the first dielectric layer 220 and thus may effectively protect the silicon-based waveguide 210.

In an embodiment, the silicon-based structure 200 further includes a supporting substrate 240 and a light-absorbing layer 250.

The light-absorbing layer 250 is located on a side of the second dielectric layer 230 away from the silicon-based waveguide 210 and is bonded onto the supporting substrate 240, thereby helping to introduce the light emitted by the active light-emitting structure 100 into the silicon-based waveguide 210. As an example, a material of the light-absorbing layer 250 may be amorphous silicon.

Certainly, if a thickness of the silicon-based waveguide 210 is large enough and has sufficient light absorption capability, the light-absorbing layer 250 may not be provided.

In an embodiment, a coupling structure (not shown) is also formed in the silicon-based waveguide 210. The coupling structure is located between the active light-emitting structure and an output end of the laser, so that coupling may be performed between the silicon-based waveguide 210 and the output end of the laser.

To be specific, in a transmission direction of the silicon-based waveguide 210, a width of the coupling structure gradually increases outward from the active light-emitting structure.

In an embodiment, a laser device including a control circuit and the abovementioned laser is also provided. The control circuit may be connected to the electrodes 120 of each laser unit of the laser, so that the laser unit with the required wavelength may be lighted as needed. The laser units of different wavelengths in the laser of the disclosure may be controlled independently. Therefore, when wavelength switching is performed, the switching speed may be effectively increased compared to conventional lasers. To be specific, the switching speed may reach nanosecond level. Herein, the problems of laser crosstalk and unstable operation may be effectively avoided.

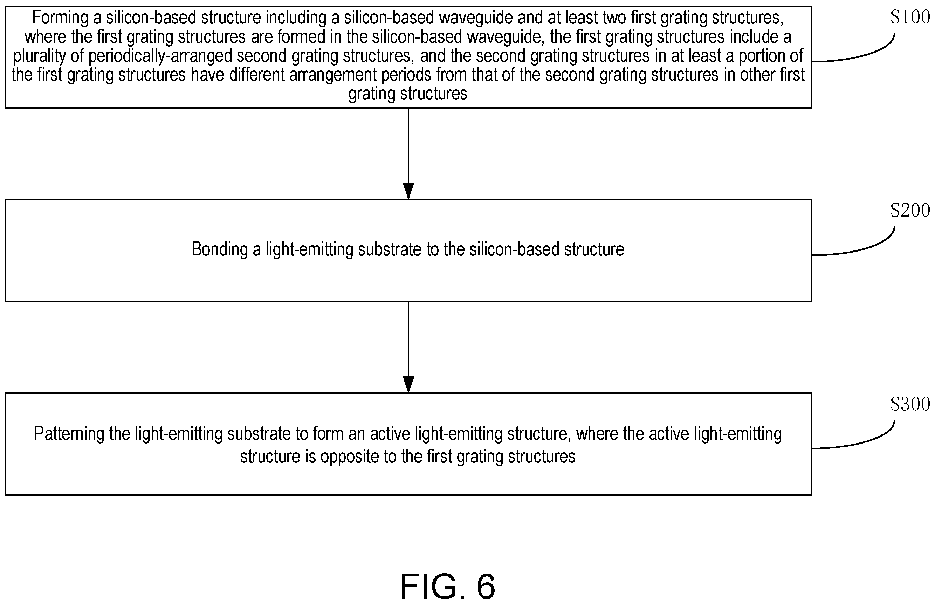

In an embodiment, with reference to FIG. 6, a fabrication method for a laser is also provided, and fabrication method includes the following steps:

In step S100, a silicon-based structure 200 is formed. The silicon-based structure 200 includes a silicon-based waveguide 210 and at least two composite gratings 211. The composite gratings 211 are formed in the silicon-based waveguide 210. Each composite grating 211 includes one primary grating and a plurality of secondary gratings, the secondary gratings are periodically arranged to form the primary grating, and the primary gratings in at least a portion of the composite gratings 211 have different grating periods from that of the primary gratings in other composite gratings 211.

In S200, a light-emitting substrate 101 is bonded to the silicon-based structure 200.

In S300, the light-emitting substrate 101 is patterned to form an active light-emitting structure 100. The active light-emitting structure 100 is opposite to the composite gratings.

In an embodiment, after step S300 is performed, the following may also be included.

In step S400, an upper covering layer 130 is formed on the active light-emitting structure 100, and the upper covering layer 130 covers the active light-emitting structure 100.

In step S500, an electrode 120 and a conductive plug 140 respectively connected to a P-type layer 111 and a N-type layer 112 of the light-emitting layer 110 of the active light-emitting structure 100 are formed on the upper covering layer.

In one embodiment, step S100 includes the following steps.

In step S110, a silicon-based substrate 201 is provided. The silicon-based substrate 201 includes a base substrate 2011, an insulating layer 2012, and a waveguide layer 2013. The insulating layer 2012 is formed on the base substrate 2011, and the waveguide layer 2013 is formed on the insulating layer 2012.

In step S120, the waveguide layer 2013 is patterned to form the silicon-based waveguide 210 and the composite gratings 211.

In step S130, a second dielectric layer 230 is formed. The second dielectric layer 230 covers a side of the silicon-based waveguide 210 on which the composite gratings 211 are formed and the insulating layer 2012.

In step S160, the base substrate 2011 is removed and the insulating layer 2012 is thinned. The remaining insulating layer 2012 forms a first dielectric layer 220.

Herein, step S200 includes the following.

The light-emitting substrate 101 is bonded to the first dielectric layer 220.

To be specific, in step S110, the silicon-based substrate 201 may be SOI. The base substrate 2011 may be a back substrate of SOI, the insulating layer 2012 may be a buried oxide layer of SOI, and the waveguide layer 2013 may be top silicon of SOI.

In step S120, the waveguide layer 2013 may be patterned through a photolithography process.

In step S130, a second dielectric material layer may be deposited on a side of the silicon-based waveguide 210 on which the composite gratings 211 are formed and the insulating layer 2012 first. Next, chemical-mechanical polishing (CMP) is performed on the second dielectric material layer, so that the second dielectric layer 230 is formed.

In step S160, the base substrate 2011 may be removed by wet etching, the insulating layer 2012 is etched to an excessively thin thickness (e.g., 20 nanometers) during the etching process, and the remaining insulating layer 2012 forms the first dielectric layer 220.

In an embodiment, the following steps are further included before step S100 is performed.

In step S150, a light-absorbing layer 250 is formed on a surface of the second dielectric layer 230.

In step S160, the light-absorbing layer 250 is bonded to the supporting substrate 240.

The composite gratings 211 are formed on the side of the silicon-based waveguide 210 away from the active light-emitting structure 100 in the above embodiment.

The composite gratings 211 may also be formed on the side of the silicon-based waveguide 210 close to the active light-emitting structure 100 in other embodiments. Herein, step S100 may include the following.

In step S1 10, the silicon-based substrate 201 is provided. The silicon-based substrate 201 includes the base substrate 2011, the insulating layer 2012, and the waveguide layer 2013. The insulating layer 2012 is formed on the base substrate 2011, and the waveguide layer 2013 is formed on the insulating layer 2012.

In step S120, the waveguide layer 2013 is patterned to form the silicon-based waveguide 210 and the composite gratings 211.

In step S180, a fourth dielectric layer is formed. The fourth dielectric layer covers the side of the silicon-based waveguide 210 on which the composite gratings 211 are formed and the insulating layer 2012.

Herein, in step S200, the silicon-based structure may be bonded to the light-emitting substrate 101 through fourth dielectric layer.

For specific limitations on the fabrication method for the laser, reference may be made to the limitations on the laser mentioned in the foregoing paragraphs, so description thereof is not repeated herein.

It should be understood that although various steps in the flow chart of FIG. 1 are shown in sequence as indicated by arrows, these steps are not necessarily executed in the order indicated by arrows. Unless explicitly stated in the specification, there is no strict order restriction on the execution of these steps, and these steps may be executed in other orders. Further, at least some of the steps in FIG. 1 may include multiple steps or multiple stages. These steps or stages are not necessarily executed at the same time, but can be executed at different times. The execution order of these steps or stages is not necessarily sequential, but may be performed in turn or alternately with other steps or at least part of the steps or stages in other steps.

In the description of the specification, descriptions with reference to the terms such as "one embodiment", "other embodiments", "ideal embodiments", etc. means that a particular feature, structure, material, or characteristic described in connection with the embodiment or example is included in at least one embodiment or example of the disclosure. In the specification, the schematic description of the above-mentioned terms does not necessarily refer to the same embodiment or example.

The technical features of the above-described embodiments may be combined arbitrarily. In order to simplify the description, not all possible combinations of the technical features in the above embodiments are described. However, as long as there is no contradiction in the combinations of these technical features, these combinations should be considered to be within the scope of the description in this specification.

The abovementioned embodiments only represent several embodiments of the disclosure, and the descriptions thereof are specific and detailed, but should not be construed as a limitation on the scope of the invention patent. It should be pointed out that for a person having ordinary skill in the art, without departing from the concept of the disclosure, several modifications and improvements can be made, which all belong to the protection scope of the disclosure. Therefore, the protection scope of the patent of the disclosure should be subject to the appended claims.

## Claims

1. A laser, **characterized in** comprising:
an active light-emitting structure, configured to emit a light; and
a silicon-based structure, bonded to the active light-emitting structure and comprising a silicon-based waveguide and at least two composite gratings, wherein the composite gratings are opposite to the active light-emitting structure and are formed in the silicon-based waveguide, the composite grating comprises one primary grating and a plurality of secondary gratings, the secondary gratings are periodically arranged to form the primary grating, and the primary gratings in at least a portion of the composite gratings have different grating periods from that of the primary gratings in other composite gratings,
wherein the silicon-based structure and the active light-emitting structure form at least two laser units, and each laser unit corresponds to one composite grating.

2. The laser according to claim 1, **characterized in that** the active light-emitting structure comprises a plurality of active light-emitting units, the active light-emitting units are all bonded to the silicon-based structure and opposite to the composite gratings, and gain materials of the active light-emitting units are different.

3. The laser according to claim 1, **characterized in that** the active light-emitting structure comprises a plurality of active light-emitting units, the active light-emitting units are all bonded to the silicon-based structure and opposite to the composite gratings, and gain materials of the active light-emitting units are the same.

4. The laser according to claim 2, **characterized in that** the same active light-emitting unit is opposite to the plurality of composite gratings.

5. The laser according to claim 1, **characterized in that** the laser units are arranged in an array, the laser units located in a same row are connected in series by the same silicon-based waveguide, and the laser units located in a same column are connected in parallel by different silicon-based waveguides.

6. The laser according to claim 5, **characterized in that** the grating periods of the primary gratings in the composite gratings corresponding to the laser units located in the same row or the same column are the same.

7. The laser according to claim 1, **characterized in that** the silicon-based structure further comprises:
a first dielectric layer, located on a side of the silicon-based waveguide on which the composite gratings are not formed and bonded to the active light-emitting structure; and
a second dielectric layer, covering a side of the silicon-based waveguide on which the composite gratings are formed and the first dielectric layer.

8. The laser according to claim 7, **characterized in that** the silicon-based structure further comprises:
a supporting substrate; and
a light-absorbing layer, located on a side of the second dielectric layer away from the silicon-based waveguide and bonded onto the supporting substrate.

9. The laser according to claim 1, **characterized in that** a coupling structure is also formed in the silicon-based waveguide, the coupling structure is located between the active light-emitting structure and an output end of the laser and is located in a transmission direction of the silicon-based waveguide, and a width of the coupling structure gradually increases outward from the active light-emitting structure.

10. A laser device, **characterized in** comprising:
the laser according to claim 1; and
a control circuit, configured to control a switch of each of the laser units.

11. A fabrication method for a laser, **characterized in** comprising:
forming a silicon-based structure, wherein the silicon-based structure comprises a silicon-based waveguide and at least two composite gratings, wherein the composite gratings are formed in the silicon-based waveguide, the composite grating comprises one primary grating and a plurality of secondary gratings, the secondary gratings are periodically arranged to form the primary grating, and the primary gratings in at least a portion of the composite gratings have different grating periods from that of the primary gratings in other composite gratings,
bonding a light-emitting substrate to the silicon-based structure; and
patterning the light-emitting substrate to form an active light-emitting structure, wherein the active light-emitting structure is opposite to the composite gratings.

12. The fabrication method for the laser according to claim 11, **characterized in that** the forming the silicon-based structure comprises:
providing a silicon-based substrate, wherein the silicon-based substrate comprises a base substrate, an insulating layer, and a waveguide layer, the insulating layer is formed on the base substrate, and the waveguide layer is formed on the insulating layer;
patterning the waveguide layer to form the silicon-based waveguide and the composite gratings;
forming a second dielectric layer, wherein the second dielectric layer covers a side of the silicon-based waveguide on which the composite gratings are formed and the insulating layer; and
removing the base substrate and thinning the insulating layer, wherein the remaining insulating layer forms a first dielectric layer,
wherein the bonding the light-emitting substrate to the silicon-based structure comprises:
bonding the light-emitting substrate to the first dielectric layer.

13. The fabrication method for the laser according to claim 12, **characterized in that** before the removing the base substrate and thinning the insulating layer, further comprising:
forming a light-absorbing layer on a surface of the second dielectric layer; and
bonding to a supporting substrate by the light-absorbing layer.
